# FASCICULE DE BREVET EUROPEEN

(11) **EP 2 705 551 B1**
(45) Date de publication et mention de la délivrance du brevet: **14.01.2015**
(21) Numéro de dépôt: 12720647.2
(22) Date de dépôt: 23.04.2012
(51) Int. Cl.: H01L 51/00

(54) **PROCÉDÉ DE CRISTALLISATION ORIENTÉE DE MATÉRIAUX**
VERFAHREN ZUR ORIENTIERTEN KRISTALLISIERUNG VON MATERIALIEN
METHOD FOR THE ORIENTED CRYSTALLIZATION OF MATERIALS

(30) Priorité: 04.05.2011 FR 1153836
(43) Date de publication de la demande: 12.03.2014
(73) Titulaire: Commissariat à l'Énergie Atomique et aux Énergies Alternatives, 75015 Paris (FR)
(72) Inventeur: BENWADIH, Mohammed, F-94500 Champigny Sur Marne (FR)
(74) Mandataire: Nony
(86) Numéro de dépôt international: PCT/IB2012/052026
(87) Numéro de publication internationale: WO 2012/150523

(56) Documents cités:
- US-A1- 2007 243 658
- US-A1- 2007 252 229
- US-A1- 2009 101 893

## Description

La présente invention se rapporte au domaine de la cristallisation de matériaux et vise en particulier à proposer un procédé utile pour contrôler et orienter la formation d'un dépôt cristallin d'un matériau en surface d'un substrat.

Elle concerne également les dispositifs, par exemple électroniques ou optoélectroniques, comportant un matériau cristallisé, notamment sous forme de film mince, obtenu selon un tel procédé.

De nos jours, de nombreux secteurs d'activité, à l'image par exemple de la chimie de spécialité, de la pharmacie ou encore de la microélectronique, mettent en oeuvre des matériaux sous la forme de cristaux. Les semi-conducteurs organiques connaissent actuellement un essor considérable dans le monde de l'électronique et des technologies de l'information. Ils peuvent en effet être substitués au silicium dans la fabrication de dispositifs électroniques ou optoélectroniques comme par exemple des dispositifs électroluminescents organiques, des dispositifs photovoltaïques organiques et des transistors organiques.

Le processus de cristallisation mis en oeuvre pour obtenir industriellement de tels cristaux est très important car il conditionne leur structure (faciès, taille,...) et leur pureté, et exerce, en conséquence, une grande influence sur leurs propriétés physiques, chimiques et/ou électroniques résultantes.

Dans le domaine de l'électronique, on recherche, en outre, généralement à obtenir des cristaux, en particulier sous la forme de films minces, à partir de matériaux organiques ou inorganiques, dans lesquels la cristallisation est homogène, et de préférence contrôlée.

De fait, la qualité des cristaux, et plus particulièrement l'ordre structural du dépôt cristallin, est primordiale. Ainsi, pour un transistor organique utilisant un matériau cristallin, il convient d'éviter, dans la zone appelée « canal de conduction », une orientation inhomogène des cristaux, des défauts comme des joints de grains, des différences de taille de grains, etc... Ces irrégularités, par la perturbation structurale qu'elles créent, peuvent fortement dégrader la mobilité des porteurs de charges, et donc la conductivité électrique au sein du matériau cristallisé.

Malheureusement, les techniques conventionnelles de dépôt d'un film cristallisé en surface d'un substrat, telles que dépôt en solution, dépôt en phase vapeur, dépôt à la tournette, dépôt par évaporation et revêtement au rouleau de même que des techniques d'impression classiques telles que le jet d'encre, ne permettent pas d'accéder à des structures cristallines de taille convenable et suffisamment homogènes pour conférer au semi-conducteur organique de bonnes propriétés électriques.

Il est à noter que cette problématique se pose également de façon analogue avec d'autres matériaux que les semi-conducteurs organiques, et notamment avec d'autres matériaux pour l'électronique tels que par exemple les diélectriques organiques (en particulier le polystyrène) ou les alliages inorganiques (en particulier les alliages du type In Cu Ga Se, utilisés dans les dispositifs photovoltaïques).

Les applications de semi-conducteurs organiques restent donc actuellement limitées au regard de leur faible conductivité électrique, conséquence directe d'une organisation structurale non optimisée du semi-conducteur organique au niveau du dépôt cristallin formé.

Deux alternatives sont principalement considérées à ce jour pour améliorer l'ordre structural des semi-conducteurs organiques, notamment dans des couches minces.

La première consiste à chauffer le substrat, généralement préalablement à l'étape de dépôt du semi-conducteur organique, pour favoriser une croissance organisée des cristaux du semi-conducteur organique.

Or, une telle étape de chauffage peut endommager, de façon irréversible, certains des constituants du dispositif visé. Elle augmente en outre nécessairement les coûts énergétiques de fabrication, ainsi que le temps de fabrication.

La seconde consiste à concevoir de nouvelles molécules de semi-conducteur organique à partir de molécules déjà connues, de manière à doter ces nouvelles molécules de semi-conducteur organique d'une meilleure aptitude à la cristallisation.

Toutefois, la conception de nouvelles molécules est généralement très coûteuse. Qui plus est, la modification de la structure moléculaire de semi-conducteurs organiques peut être préjudiciable aux propriétés électriques et/ou mécaniques du matériau dans le dispositif résultant. En outre, la modification de la structure moléculaire du semi-conducteur organique peut également affecter ses propriétés physico-chimiques, par exemple sa solubilité.

Afin de suppléer à ces inconvénients, d'autres techniques de cristallisation ont déjà été proposées.

Par exemple, le document US 2007/0243658 décrit un procédé de fabrication d'un film mince de semi-conducteurs organiques cristallisés sur un substrat comprenant une première étape de revêtement dudit substrat avec une solution dudit semi-conducteur organique suivie d'une étape de cristallisation dudit semi-conducteur organique initiée à partir de l'extrémité dudit revêtement.

Plus récemment, le document US 2009/0101893 a décrit un procédé de fabrication d'un transistor organique à couche mince impliquant d'« ensemencer » la surface devant être cristallisée avec des sites de cristallisation destinés à initier la cristallisation d'un dépôt consécutif de semi-conducteur organique.

Ainsi, il serait avantageux de disposer d'un nouveau procédé permettant une croissance organisée et dirigée du semi-conducteur à cristalliser afin d'éviter dans le canal tout obstacle à la conduction électrique, en vue d'améliorer les performances électriques du transistor résultant.

La présente invention vise précisément à proposer un nouveau procédé utile pour orienter la cristallisation d'un matériau en surface d'au moins une face d'un substrat.

Elle vise notamment à permettre l'obtention d'un dépôt cristallisé, notamment sous la forme d'un film mince, dans lequel l'homogénéité et l'orientation de la cristallisation sont optimisées dans au moins une zone prédéterminée dite « zone d'intérêt ».

Ainsi, la présente invention concerne, selon un premier de ses aspects, un procédé utile pour orienter la cristallisation d'un matériau sur une zone de surface d'au moins une face d'un substrat, comprenant au moins les étapes consistant à :
i. déterminer, sur ladite face, la surface sur laquelle doit être formé le dépôt cristallin, dite zone d'intérêt,
ii. déposer, sur ladite face et à la périphérie de ladite zone d'intérêt, au moins une particule dédiée à former un germe de cristallisation,
iii. mettre en contact ladite particule avec au moins ledit matériau à cristalliser,
iv. exposer au moins ledit point de contact entre ladite particule et ledit matériau à cristalliser à des conditions favorables à la cristallisation dudit matériau,
ledit procédé étant caractérisé en ce que la surface de ladite particule est en partie fonctionnalisée par au moins un groupement dit à affinité pour ledit matériau à cristalliser, ledit groupement possédant au moins un motif de nature chimique identique ou apparentée à au moins une partie de la structure chimique dudit matériau à cristalliser,
et en ce que ladite particule est déposée en étape ii. de manière à exposer ledit groupement face à la zone d'intérêt.

De manière surprenante, les inventeurs ont constaté qu'il est possible d'orienter la cristallisation au moyen d'une particule fonctionnalisée déposée à la surface sur laquelle doit être formé le dépôt cristallin.

En effet, dans le cadre de la présente invention, la molécule partiellement fonctionnalisée va permettre d'initier et d'orienter la germination et/ou la croissance du matériau à cristalliser, de manière localisée, orientée et organisée selon la direction de la partie fonctionnalisée de la surface de la particule.

Le procédé de l'invention s'avère avantageux à plusieurs titres.

Tout d'abord, il permet de maitriser et contrôler le point de départ de la cristallisation, mais également la direction de croissance de la cristallisation.

Le matériau cristallisé obtenu grâce au procédé selon l'invention est homogène, organisé avec un facteur d'ordre très grand et orienté sur la zone d'intérêt.

Selon un mode avantageux de réalisation, ce dépôt cristallin peut être même constitué d'un seul grain monocristallin du matériau considéré.

Ainsi, dans le cas où le matériau à cristalliser est un semi-conducteur organique, le procédé selon l'invention permet d'obtenir un dépôt cristallin de très bonne qualité, présentant une très bonne mobilité des porteurs de charges, et donc des propriétés électriques très satisfaisantes, dans la zone d'intérêt.

Enfin, le procédé selon l'invention présente l'avantage d'être facile à mettre en oeuvre, dans la mesure où il est compatible avec la mise en oeuvre de techniques conventionnelles de dépôt ou d'impression, et d'être ainsi peu coûteux.

L'invention concerne également, selon un autre de ses aspects, un dispositif, par exemple photovoltaïque ou photoconducteur, comprenant un dépôt cristallin, notamment sous la forme d'un film mince, obtenu par le procédé selon l'invention. Il s'agit avantageusement de transistors, notamment à effet de champ et de diodes.

D'autres caractéristiques, variantes et avantages du procédé selon l'invention ressortiront mieux à la lecture de la description, des exemples et figures qui vont suivre, donnés à titre illustratif et non limitatif.

Dans la suite du texte, les expressions « compris entre ... et ... », « allant de ... à ... » et « variant de ... à ... » sont équivalentes et entendent signifier que les bornes sont incluses, sauf mention contraire.

Sauf indication contraire, l'expression « comportant/comprenant un(e) » doit être comprise comme « comportant/comprenant au moins un(e) ».

### PROCEDE

### ETAPE (i)

Le procédé selon l'invention implique, dans un premier temps, de déterminer sur la face du substrat considéré une zone de surface particulière correspondant à la surface sur laquelle le dépôt cristallin du matériau considéré est destiné à être formé.

### Substrat

Dans le cadre de la présente invention, le terme « substrat » fait référence à une structure de base à la surface de laquelle est formé le dépôt cristallin du matériau considéré selon l'invention.

Le procédé selon l'invention peut avantageusement être mis en oeuvre sur des substrats variés.

Ce substrat peut donc être de nature très diverse, organique ou inorganique, voire de nature composite c'est-à-dire formé de plusieurs matériaux distincts.

Le substrat peut être ainsi à base de silicium, de verre, d'un métal et/ou d'une résine et se présenter généralement sous la forme d'une plaque, d'une feuille ou d'un film. Il s'agira plus particulièrement d'un substrat à base de résine.

A titre d'exemple de matériaux susceptibles de former un tel substrat, on peut notamment citer la silice, le silicium, le téraphtalate de polyéthylène (PET), le naphtalate de polyéthyle (PEN), le polyimide (PI), le polyéther imide (PEI), le polyéther sulfone (PES), le polysulfone (PSF), le sulfure de polyphénylène (PPS), le polyéther éther cétone (PEEK), le polyacrylate (PA), le polyamide imide (PAI), le polystyrène, le polyéthylène, le polypropylène, une résine polyamine, une résine carbonate ou encore une résine cellulosique.

Il peut notamment s'agir d'un matériau composite formé par des zones conductrices, notamment métalliques, juxtaposées à des zones isolantes.

Le substrat peut, le cas échéant, subir préalablement à son traitement selon l'invention, une à plusieurs transformations dédiées par exemple à lui conférer des spécificités particulières telles que par exemple une fonctionnalisation avec un ou plusieurs matériaux annexes, tels que par exemple des métaux pour former une ou plusieurs électrodes.

Ainsi, le procédé selon la présente invention s'avère particulièrement avantageux pour former les films minces, par exemple de semi-conducteurs organiques, requis dans le domaine de l'électronique et notamment des transistors, comme illustré dans l'exemple qui suit.

### Zone d'intérêt

La zone de surface sur laquelle doit être formé le dépôt cristallin est intitulée « zone d'intérêt » dans le cadre de la présente invention.

Pour des raisons évidentes, il existe toujours une zone dans laquelle le dépôt cristallin doit être le plus homogène possible, et en particulier le plus exempt de défauts cristallins possible.

Par « défaut cristallin », on entend notamment désigner les interfaces entre deux cristaux dans une structure polycristalline (également appelées joints de grains).

La « zone d'intérêt » au sens de l'invention peut ainsi être définie comme étant la surface où le dépôt cristallin doit être le plus uniforme possible, voire être constitué d'un seul grain monocristallin.

Des exemples de « zones d'intérêt » au sens de l'invention sont indiqués ci-après, à titre illustratif et non limitatif.

Ainsi, lorsque le matériau à cristalliser est un semi-conducteur organique, la «zone d'intérêt» au sens de l'invention est la surface au sein de laquelle un courant d'électrons ou de trous doit être transporté.

Ainsi, dans le cas particulier d'un transistor, la « zone d'intérêt » au sens de l'invention associée à un matériau à cristalliser de type semi-conducteur organique est la zone du canal comprise entre les électrodes de source et de drain.

D'autres exemples de zones d'intérêt au sens de l'invention se trouvent notamment dans les diodes, les capacités, en particulier les capacités MIS (métal/isolant/semi-conducteur), ou encore les détecteurs optiques.

### ETAPE (ii)

Le procédé selon l'invention comprend au moins une deuxième étape (ii) consistant à déposer sur ladite face et à la périphérie de ladite zone d'intérêt, au moins une particule dédiée à former un germe de cristallisation.

### Particule fonctionnalisée selon l'invention

Selon un des aspects de l'invention, la particule dédiée à former un germe de cristallisation présente une partie de sa surface fonctionnalisée par au moins un groupement à affinité pour ledit matériau à cristalliser.

Elle peut présenter une taille allant de 10 nm à 100 µm, voire même supérieure à 100 µm.

La taille de la particule peut être adaptée à la dimension de la zone d'intérêt afin d'assurer la meilleure cristallisation dans cette zone.

Par exemple, la particule peut présenter une dimension proche de la dimension du côté de la zone d'intérêt où elle sera positionnée : la cristallisation se propagera ainsi de façon homogène sur toute la surface.

Sa forme peut aussi être adaptée : par exemple, une forme longiligne pour une zone d'intérêt en forme de parallélogramme.

Enfin, les particules peuvent être réparties le long d'un des côtés de la zone d'intérêt pour homogénéiser aussi le front de croissance.

Il peut s'agir d'une particule choisie parmi les particules semi-conductrices telles que les particules de Si, de Ge ou de pentacène ; les particules isolantes telles que les particules de silice, de polystyrène, ou de Téflon^{®} ; les particules conductrices telles que les particules de Ni, PDOT (poly(3,4-éthylènedioxythiophène)) ou ITO (indium tin oxyde), et les particules céramiques telles que les particules de titanate de baryum BaTiO₃.

De préférence, ladite particule est inorganique. En particulier, elle peut être formée en tout ou partie d'oxyde, avantageusement de silice, d'alumine, de titanate de baryum (BaTiO₃).

Selon un mode de réalisation particulier, la particule est une particule de silice.

Comme évoqué précédemment, la particule est fonctionnalisée, sur une partie de sa surface, par un groupement à affinité pour le matériau à cristalliser.

Plus particulièrement, on entend, dans le cadre de l'invention, par « groupement à affinité pour ledit matériau à cristalliser », un groupement possédant au moins un motif de nature chimique identique ou apparentée à au moins une partie de la structure chimique dudit matériau à cristalliser.

La nature du groupement de fonctionnalisation de la particule, et plus particulièrement dudit motif porté par ce groupement, est bien entendu choisie au regard du matériau à cristalliser considéré.

En particulier, dans le cadre de la mise en oeuvre du procédé de l'invention pour la cristallisation d'un matériau de nature chimique aromatique, ledit groupement de fonctionnalisation peut posséder avantageusement un motif aromatique, en particulier phényle.

### Réparation de la particule partiellement fonctionnalisée

Une particule partiellement fonctionnalisée selon l'invention peut être préparée selon des techniques de fonctionnalisation connues de l'homme du métier.

La fonctionnalisation par ledit groupement spécifique décrit précédemment peut être ainsi opérée par greffage sur ladite partie de la surface de la particule, d'une molécule, comprenant ledit motif chimique considéré pour constituer une monocouche auto-assemblée, encore appelée SAM (en anglais : « Self-Assembled Monolayer »). La molécule de la SAM présente en particulier, outre le groupement spécifique, au moins une fonction dite réactive apte à permettre son greffage à la surface de la particule.

Bien entendu, le motif chimique du groupement considéré selon l'invention est totalement inerte vis-à-vis de la surface de ladite particule à fonctionnaliser.

Par « inerte », encore indifféremment dit « non réactif », on entend signifier que ledit motif ne réagit ou n'interagit pas ou n'induit aucune action avec la surface à fonctionnaliser.

A l'issue du greffage de la SAM, la particule présente une partie de sa surface fonctionnalisée par lesdits groupements possédant le motif chimique spécifique.

Selon une première variante de réalisation, la fonctionnalisation de la surface considérée de la particule peut être effectuée directement, par exemple par un traitement sous vide, en déposant une SAM sur la partie de la surface à fonctionnaliser.

Les particules peuvent ainsi déjà présenter une surface comportant des fonctions aptes à interagir avec ladite fonction réactive de la molécule porteuse dudit groupement considéré, pour permettre son greffage.

Alternativement, la fonctionnalisation d'une partie de la surface de la particule peut nécessiter un traitement préalable de ladite partie de surface de la particule afin d'y générer des fonctions aptes à interagir avec ladite fonction réactive de la SAM pour permettre son greffage.

Plus particulièrement, l'interaction de la fonction réactive de ladite SAM et de la fonction générée sur ladite surface de la particule permet l'établissement d'une liaison covalente entre lesdites fonctions.

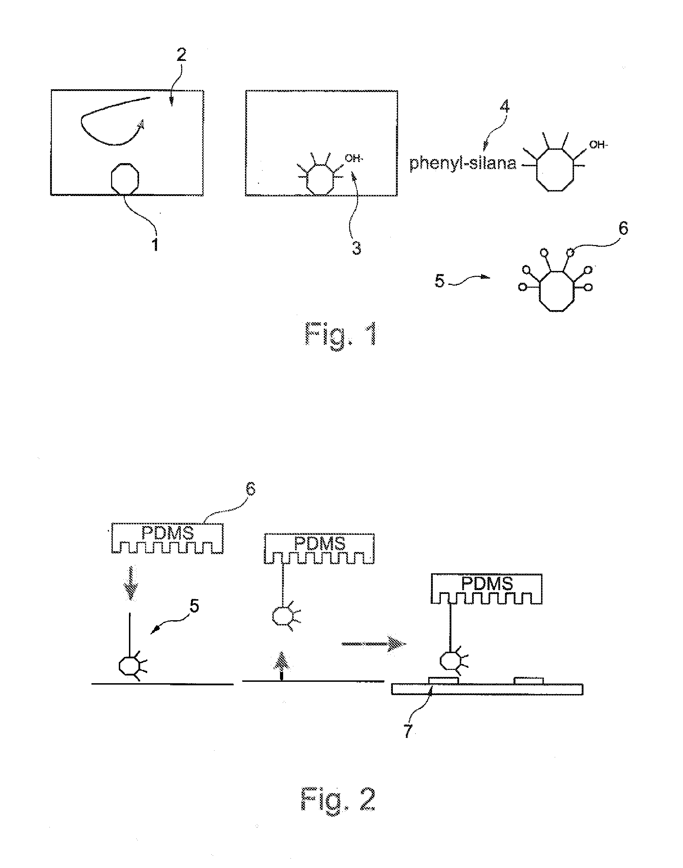

A titre d'exemple, la fonctionnalisation d'une partie de la surface d'une particule peut être opérée comme décrit ci-après et illustré en FIGURE 1.

La particule à fonctionnaliser (1), par exemple une particule de silice, peut être préalablement traitée, par exemple *via* un traitement plasma, notamment *via* un plasma de dioxygène (2), pour générer sur la partie de la surface de la particule exposée au plasma, des fonctions hydroxyle (3).

La fonctionnalisation de ladite surface par lesdits groupements est ensuite assurée par mise en contact de ladite surface avec une molécule porteuse dudit groupement présentant ledit motif à affinité pour le matériau à cristalliser, par exemple un radical phényle pour les matériaux aromatiques, et d'une fonction réactive apte à interagir avec une fonction hydroxyle de la surface pour former une liaison covalente.

La particule présentant sur une partie de sa surface des fonctions hydroxyle est par exemple plongée dans une solution comprenant la molécule de la SAM.

La molécule de la SAM (4) peut par exemple porter, outre le motif aromatique notamment phényle d'intérêt, au moins une fonction silane ou chlore ou isocyanate, apte à interagir avec une fonction hydroxyle de la surface par réaction de silanisation, chlorure-silice ou isocyanate-silice, pour former une liaison covalente.

Une telle molécule peut être en particulier le phénytriisopropylsilane ou le phényltriméthoxysilane, de préférence le phényltriisopropylsilane.

A l'issue de ce traitement de fonctionnalisation, la particule finale (5) obtenue est fonctionnalisée, sur la partie de sa surface préalablement porteuse de fonctions hydroxyles, par des groupements possédant un motif phényle (6).

Bien entendu, l'homme du métier sera à même de mettre en oeuvre toute autre technique adéquate pour fonctionnaliser une partie de la surface d'une particule par un groupement porteur d'un motif approprié au regard du matériau à cristalliser.

### Bifonctionnalisation de la particule

Selon une variante de réalisation, la particule est bifonctionnalisée.

Par « bifonctionnalisée », on entend signifier que deux parties distinctes de la surface de la particule sont fonctionnalisées par des groupements distincts.

Plus particulièrement, outre la partie fonctionnalisée par ledit groupement à affinité pour le matériau à cristalliser, ladite particule peut être fonctionnalisée sur une autre partie de sa surface par un groupement dénué d'affinité pour ledit matériau à cristalliser.

Selon un mode de réalisation particulièrement avantageux, lesdits groupements à affinité pour le matériau à cristalliser et lesdits groupements dénués d'affinité pour ledit matériau à cristalliser sont disposés sur des faces différentes, de préférence opposées de ladite particule.

Ainsi, selon un mode de réalisation particulièrement avantageux, la particule présente deux faces très différentes, une face qui présentera une affinité avec ledit matériau à cristalliser et une autre face qui repoussera fortement ledit matériau à cristalliser.

Lesdits groupements dénués d'affinité pour le matériau à cristalliser sont tels qu'aucune cristallisation ne peut être initiée lors de la mise en contact dudit matériau à cristalliser et de la partie de la surface de la particule fonctionnalisée par ledit groupement dénué d'affinité pour le matériau à cristalliser.

Le choix du groupement dénué d'affinité pour ledit matériau à cristalliser et de mise en oeuvre d'une technique adéquate de bifonctionnalisation font partie des compétences de l'homme du métier.

La bifonctionnalisation de la particule peut par exemple être opérée *via* deux étapes consécutives de traitement plasma, telles que décrites plus particulièrement par la suite.

Bien entendu, la nature du groupement dénué d'affinité pour le matériau à cristalliser dépend de la nature du matériau à cristalliser.

A titre d'exemple, pour un matériau à cristalliser de nature chimique aromatique, ledit groupement dénué d'affinité peut figurer un atome de fluor ou une amine, en particulier un atome de fluor.

Par exemple, dans le cas décrit précédemment de la fonctionnalisation de la particule par un groupement porteur d'un motif phényle, la particule préalablement fonctionnalisée sur une partie de sa surface par des fonctions hydroxyle peut, préalablement à son introduction dans la solution comprenant la molécule de la SAM, être exposée à un plasma fluoré, de manière à fonctionnaliser la partie de sa surface ne comprenant pas de fonctions hydroxyle, par des atomes de fluor.

La particule obtenue est ainsi fonctionnalisée sur l'une de ses faces par des fonctions hydroxyles et sur l'autre face, par des atomes de fluor. La particule est ensuite immergée dans une solution comprenant la molécule de type dérivé de silane, notamment le phénytriisopropylsilane ou le phényltriméthoxysilane. Le fluor, la différence des fonctions hydroxyle, n'est pas apte à interagir avec une fonction silane de la molécule mise en oeuvre. Dès lors, la molécule ne peut se greffer que sur la partie de la surface de la molécule comportant des fonctions hydroxyles.

A l'issue de ce traitement, la particule finale présente une partie de sa surface fonctionnalisée par des groupements possédant un motif phényle et une autre partie de sa surface comportant des atomes de fluor.

### Dépôt de ladite particule

Comme évoqué précédemment, selon un des aspects de l'invention, la particule est déposée selon l'étape (ii) sur ladite face de manière à exposer ledit groupement à affinité pour le matériau à cristalliser, face à la zone à d'intérêt.

Dans le cadre de la présente invention, ladite particule est déposée à l'extérieur de la zone d'intérêt, plus particulièrement à la périphérie de la zone d'intérêt.

L'homme du métier sera à même de mettre en oeuvre les techniques adaptées pour transférer la particule à l'emplacement souhaité sur ladite face et selon l'orientation souhaitée.

La particule peut être déposée selon l'orientation souhaitée en étape (ii) en surface de ladite face par diverses méthodes, en particulier par sérigraphie, jet d'encre, tampon ou dépôt sous vide.

Selon un mode de réalisation particulier, elle peut être déposée à l'aide d'un tampon, notamment un tampon en élastomère, et plus particulièrement en polydiméthylsiloxane (PDMSD).

La FIGURE 2 schématise le transfert de la particule partiellement fonctionnalisée (5) à l'aide d'un tampon PDMS (6) et son dépôt sur l'une des électrodes (7) source ou drain d'un transistor.

### ETAPE (iii)

Le procédé de l'invention comprend également une troisième étape (iii) consistant à mettre en contact ladite particule avec au moins ledit matériau à cristalliser.

### Matériau à cristalliser

Les matériaux considérés dans le cadre de l'invention peuvent être des matériaux organiques ou inorganiques possédant une forte valeur ajoutée dans le domaine de l'électronique lorsqu'ils se présentent sous une forme cristallisée.

Il pourra notamment s'agir de matériaux organiques ou inorganiques dotés de propriétés isolantes ou conductrices à l'état cristallisé.

A titre d'exemple de tels matériaux, on peut notamment citer des diélectriques organiques (en particulier le polystyrène), des alliages inorganiques (en particulier les alliages du type In Cu Ga Se, utilisés dans les dispositifs photovoltaïques) ou encore des semi-conducteurs organiques, notamment tels que décrits ci-après.

Selon un mode de réalisation particulier, il s'agit de matériaux aptes à cristalliser à partir d'une solution liquide.

### Semi-conducteur organique

Selon un mode préféré de réalisation, le matériau considéré selon l'invention est un semi-conducteur organique.

Les semi-conducteurs organiques considérés dans le cadre de la présente invention peuvent être de deux types.

Il peut s'agir de molécules de faible masse moléculaire (couramment appelées « petites molécules »), et notamment de molécules de masse moléculaire inférieure à 1000 g/mol, ou de polymères constitués de macromolécules de plus grande masse moléculaire.

Ces deux types de semi-conducteurs organiques ont pour point commun de présenter un système conjugué provenant de l'alternance de simples et de doubles liaisons carbone-carbone.

A titre de semi-conducteur organique de faible masse moléculaire, on peut par exemple citer ceux de type polyacène, oligo-thiophène ou phtalocyanine.

A titre de semi-conducteur organique polymère, on peut par exemple citer ceux de type polyacétylène, polyphénylène, polythiophène ou poly(phénylène/vinylène).

Il pourra notamment s'agir d'un semi-conducteur organique choisi parmi l'un de pentacène, tétracène, anthracène, naphthalène, alpha-6-thiophène, alpha-4-thiophène, pérylène et ses dérivés, rubrène et ses dérivés, coronène et ses dérivés, diimide tétracarboxylique de pérylène et ses dérivés, dianhydride tétracarboxylique de pérylène et ses dérivés, polythiophène et ses dérivés, polyparaphenylène-vinylène et ses dérivés, polyparaphénylène et ses dérivés, polyfluorène et ses dérivés, copolymère polyfluorène-oligothiophène et ses dérivés, polythiophène-vinylène et ses dérivés, un copolymère aromatique hétérocyclique de polythiophène et ses dérivés, oligonaphthalène et ses dérivés, alpha-5-thiophène oligothiophène et ses dérivés, phthalocyanine qui ne contient pas de métal et ses dérivés, dianhydride pyromellitique et ses dérivés, diimide pyromellitique et ses dérivés, dianhydride d'acide tétracarboxylique de pérylène et ses dérivés, diimide tétracarboxylique de pérylène et ses dérivés, diimide tétracarboxylique de naphtalène et ses dérivés ou dianhydride-acide tétracarboxylique de naphtalène et ses dérivés.

Selon un mode préféré de réalisation, le semi-conducteur organique est choisi parmi le pentacène, le tétracène et l'anthracène. Il s'agira de préférence du pentacène.

Selon un mode de réalisation particulièrement préféré, l'étape (iii) est opérée par dépôt sur la zone d'intérêt d'un film continu d'un milieu solvant comprenant au moins le matériau à cristalliser considéré selon l'invention, ledit film venant au contact de ladite particule.

Le procédé selon l'invention peut ainsi comprendre une étape consistant à formuler ledit matériau à cristalliser à l'état de soluté dans le milieu solvant.

Dans le cadre de cette variante de réalisation, le film déposé peut présenter une épaisseur inférieure ou égale à 1 mm, de préférence inférieure ou égale à 200 µm.

Ce film est plus particulièrement continu, c'est-à-dire qu'un même film ininterrompu est déposé sur la zone d'intérêt et au moins jusqu'au contact avec ladite particule.

Un tel film continu peut être obtenu par toute technique de dépôt connue de l'homme du métier pour former des films minces sur un support.

Le choix d'une technique de dépôt convenable fait partie des compétences de l'homme du métier, qui sélectionnera la technique adaptée en fonction notamment de la nature du substrat considéré ainsi que des propriétés de dépôt recherchées.

Selon un mode de réalisation, le film peut être déposé par stamping, dépôt à la tournette, héliogravure, flexographie, impression jet d'encre, offset, ou encore sérigraphie.

Dans le cadre de ce mode de réalisation, le matériau à cristalliser, présent à l'état de soluté au sein du milieu solvant, doit être présent en une concentration inférieure à sa concentration de sursaturation critique.

Par « concentration de sursaturation critique », on entend désigner, au sens de l'invention, la limite entre l'état de soluté et l'état solide, c'est-à-dire le stade où le matériau franchit l'équilibre soluté/milieu solvant pour précipiter.

Les conditions à respecter pour qu'un état de sursaturation puisse effectivement être atteint de façon localisée au contact de la particule font partie des compétences de l'homme du métier.

Bien entendu, la mise en contact en étape (iii) dudit matériau à cristalliser avec ladite particule déposée en étape (ii) peut être opérée par d'autres techniques connues de l'homme du métier, comme par exemple par dépôt sous vide ou dépôt physique en phase vapeur.

### ETAPE (iv)

Le procédé selon l'invention comprend enfin une quatrième étape (iv) consistant à exposer ledit point de contact entre ladite particule et ledit matériau à cristalliser à des conditions favorables à la cristallisation dudit matériau.

Les conditions à mettre en oeuvre pour réaliser cette étape relèvent des compétences de l'homme du métier.

Dans le cadre du dépôt en étape (iii) d'un film d'un milieu solvant comprenant ledit matériau à cristalliser, l'étape (iv) peut notamment comprendre au moins l'évaporation du milieu solvant.

De manière avantageuse, la cristallisation est initiée de façon localisée à partir de la particule déposée en étape (ii).

Avantageusement, la cristallisation progresse à partir de ladite particule de manière organisée et orientée selon la direction déterminée par la partie de la surface de la particule fonctionnalisée par ledit groupement à affinité pour le matériau à cristalliser.

En particulier, le dépôt cristallin orienté obtenu est homogène dans la seule direction déterminée par ladite surface, avec un facteur d'ordre cristallographique très grand, de préférence constitué d'un seul grain monocristallin du matériau à cristalliser.

Dans le cadre du mode de réalisation particulier dans lequel la particule est bifonctionnalisée, comme décrit précédemment, la cristallisation n'est initiée que sur la face comportant ledit groupement à affinité pour ledit matériau à cristalliser. Il y a donc croissance du matériau à cristalliser, de manière orientée et homogène, uniquement dans la direction déterminée par cette face.

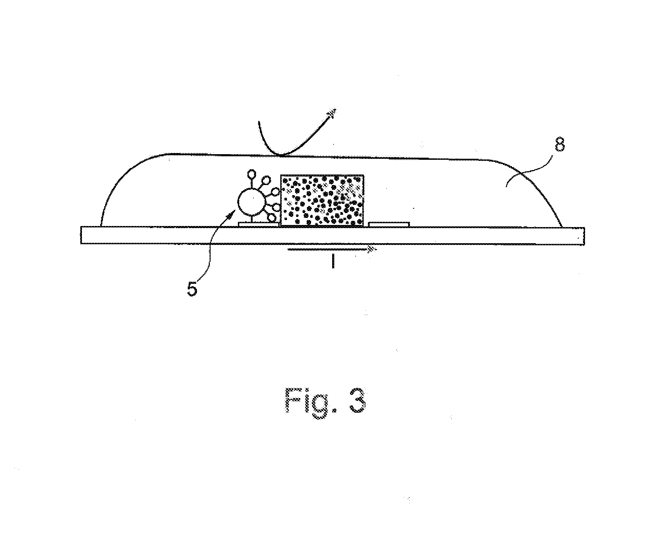

La FIGURE 3 schématise le film (8) continu d'un milieu solvant comprenant ledit matériau à cristalliser, déposé sur la zone d'intérêt et venant au contact de ladite particule (5). La cristallisation est initiée à partir de ladite particule et progresse, simultanément à l'évaporation du milieu solvant, de manière homogène selon la direction (I) déterminée par la face de la surface de la particule fonctionnalisée par ledit groupement à affinité pour le matériau à cristalliser (5).

### APPLICATIONS

Le procédé selon l'invention s'avère particulièrement avantageux pour former des films minces, par exemple de semi-conducteurs organiques requis dans le domaine de l'électronique, et notamment des transistors.

En particulier, selon un mode de réalisation, le matériau à cristalliser peut être un semi-conducteur organique. Ladite zone d'intérêt peut être alors la zone du canal d'un transistor et la particule peut être déposée sur ou à la périphérie d'au moins l'une des électrodes dudit transistor, ledit groupement à affinité pour le matériau à cristalliser étant exposé face à la zone du canal.

Dans ce cas, le cristal formé s'étendra dans la zone du canal, de préférence sous la forme d'un seul grain monocristallin.

Le procédé selon l'invention peut être également mis en oeuvre à l'égard de tout dispositif nécessitant la présence d'un film mince d'un matériau de très bonne qualité cristalline, à l'image par exemple des diodes, des capacités MIS et des détecteurs.

Par exemple, le dispositif peut être une diode, le matériau à cristalliser étant un semi-conducteur et la zone d'intérêt étant située entre les deux électrodes.

En particulier, ladite zone d'intérêt est la zone active d'une diode et ladite particule est déposée sur ou à la périphérie d'au moins l'une des électrodes de la diode, ledit groupement à affinité pour le matériau à cristalliser étant exposé face à la zone active.

Il peut également s'agir d'une capacité, le matériau à cristalliser étant alors un isolant et la zone d'intérêt étant située entre les deux armatures de la capacité.

Selon un autre mode de réalisation, ledit matériau à cristalliser est un isolant, par exemple le polystyrène. Ladite zone d'intérêt peut être alors l'oxyde de grille d'un transistor ou le diélectrique d'une capacité et ladite particule est déposée à la périphérie des électrodes.

Les exemples de réalisation indiqués ci-après ou représentés en Figures 1, 2 et 3 sont uniquement donnés à titre illustratif et non limitatif de l'invention.
Figure 1 : Représentation schématique de la fonctionnalisation d'une partie de la surface d'une particule par un groupement porteur d'un motif phényle.
Figure 2 : Représentation schématique du dépôt de la particule fonctionnalisée à l'aide d'un tampon PDMS sur l'une des électrodes source ou drain d'un transistor.
Figure 3 : Représentation schématique du dépôt d'un film continu du milieu solvant comprenant ledit matériau à cristalliser.

### EXEMPLE

Un transistor ayant les caractéristiques suivantes a été préparé en mettant en oeuvre le procédé selon l'invention.

### Dépôt des électrodes source et drain

Sur un substrat sous forme d'une plaque en PEN (polyéthylène naphtalate), on a déposé des électrodes (source et drain).

### Préparation d'une particule fonctionnalisée selon l'invention

Une nanoparticule de silice (SiO₂) a été fonctionnalisée sur l'une de ses faces par un groupement possédant un motif phényle selon la méthode suivante.

La nanoparticule de silice a subi un traitement plasma au sein d'une enceinte de plasma oxygène. Ce traitement plasma permet de créer des fonctions pendantes OH⁻ sur la partie de la surface de la particule en regard du plasma.

La particule est ensuite plongée dans une solution de molécule phényltriisopropylsilane. L'interaction des fonctions silane des molécules avec les fonctions hydroxyle conduit au greffage des molécules sur la partie de la surface préalablement fonctionnalisée par les fonctions hydroxyle. La particule obtenue présente une partie de sa surface fonctionnalisée par des groupements possédant un motif phényle.

### Dépôt de la particule

La particule obtenue à l'issue de l'étape précédente a été déposée en surface de l'une des électrodes source ou drain du transistor, à l'aide d'un tampon PDMS (polydiméthylsiloxane), la face traitée de la nanoparticule par lesdits groupements à motif phényle étant orientée vers le canal de conduction.

### Mise en contact de la particule avec le matériau à cristalliser.

Le semi-conducteur (pentacène liquide) a été déposé sous la forme d'un film sur toute la plaque.

Le milieu solvant a ensuite été évaporé à 60 °C pendant 3 minutes puis à 100 °C pendant 1 minute.

La cristallisation est initiée au contact de la particule. Elle est orientée et organisée selon la direction de la face de la particule fonctionnalisée par les groupements porteurs de motifs phényle.

### Dépôts du diélectriques de grille et de la grille conductrice

On a enfin procédé au dépôt du diélectrique (polystyrène) par sérigraphie, puis au dépôt par jet d'encre d'Ag pour constituer la grille du transistor.

## Revendications

1. Procédé utile pour orienter la cristallisation d'un matériau sur une zone de surface d'au moins une face d'un substrat, comprenant au moins les étapes consistant à :
i. déterminer, sur ladite face, la surface sur laquelle doit être formé le dépôt cristallin, dite zone d'intérêt,
ii. déposer, sur ladite face et à la périphérie de ladite zone d'intérêt, au moins une particule dédiée à former un germe de cristallisation,
iii. mettre en contact ladite particule avec au moins ledit matériau à cristalliser,
iv. exposer au moins ledit point de contact entre ladite particule et ledit matériau à cristalliser à des conditions favorables à la cristallisation dudit matériau,
la surface de ladite particule étant en partie fonctionnalisée par au moins un groupement à affinité pour ledit matériau à cristalliser, ledit groupement possédant au moins un motif de nature chimique identique ou apparentée à au moins une partie de la structure chimique dudit matériau à cristalliser, et en ce que ladite particule est déposée en étape ii. de manière à exposer ledit groupement face à la zone à cristalliser.

2. Procédé selon la revendication 1, dans lequel le dépôt cristallin formé sur la zone d'intérêt est constitué d'un seul grain monocristallin dudit matériau.

3. Procédé selon l'une quelconque des revendications précédentes, dans lequel ladite particule est inorganique, en particulier est formée en tout ou partie d'un oxyde, avantageusement de silice, d'alumine ou de titanate de baryum, et plus particulièrement est une particule de silice.

4. Procédé selon l'une quelconque des revendications précédentes, mettant en oeuvre une particule dont la surface est en partie fonctionnalisée par un groupement possédant au moins un motif aromatique, en particulier phényle, pour un matériau à cristalliser de nature chimique aromatique.

5. Procédé selon la revendication précédente, dans lequel ladite particule partiellement fonctionnalisée est obtenue par greffage, sur une particule présentant sur une partie de sa surface des fonctions hydroxyles, d'une molécule présentant, outre ledit groupement à motif aromatique notamment phényle, au moins une fonction silane ou chlore ou isocyanate apte à interagir avec une fonction hydroxyle de la surface pour former une liaison covalente.

6. Procédé selon la revendication précédente, **caractérisé en ce que** ladite molécule est le phénytriisopropylsilane ou le phényltriméthoxysilane, de préférence le phényltriisopropylsilane.

7. Procédé selon les revendications 5 ou 6, dans lequel ladite particule présentant sur une partie de sa surface des fonctions hydroxyles est obtenue par un traitement plasma d'une particule non fonctionnalisée, notamment un plasma de dioxygène, pour générer sur la partie de la surface de la particule exposée au plasma, des fonctions hydroxyle.

8. Procédé selon l'une quelconque des revendications précédentes, dans lequel ladite particule est en outre fonctionnalisée, sur une partie de sa surface distincte de celle fonctionnalisée par ledit groupement à affinité pour ledit matériau à cristalliser, par au moins un groupement dénué d'affinité pour ledit matériau à cristalliser.

9. Procédé selon la revendication 8, dans lequel lesdits groupements à affinité pour le matériau à cristalliser et lesdits groupements dénués d'affinité pour ledit matériau sont disposés sur des faces différentes, de préférence des faces opposées, de ladite particule.

10. Procédé selon l'une quelconque des revendications précédentes, dans lequel ladite particule est déposée selon l'orientation souhaitée en étape (ii) en surface de ladite face par sérigraphie, jet d'encre, tampon ou dépôt sous vide, en particulier à l'aide d'un tampon en élastomère notamment en polydiméthylsiloxane.

11. Procédé selon l'une quelconque des revendications précédentes, **caractérisé en ce que** la mise en contact de ladite particule avec ledit matériau à cristalliser dans l'étape (iii) est effectuée par dépôt sur ladite zone d'intérêt d'un film continu d'un milieu solvant comprenant au moins ledit matériau à cristalliser, ledit film venant au contact de ladite particule.

12. Procédé selon la revendication précédente, dans lequel l'étape (iv) comprend au moins l'évaporation dudit milieu solvant.

13. Procédé selon l'une quelconque des revendications précédentes, dans lequel ledit matériau à cristalliser est un semi-conducteur organique.

14. Procédé selon la revendication 13, dans lequel ladite zone d'intérêt est la zone du canal d'un transistor et ladite particule est déposée sur ou à la périphérie d'au moins l'une des électrodes dudit transistor, ledit groupement à affinité pour le matériau à cristalliser étant exposé face à la zone du canal.

15. Procédé selon la revendication 13, dans lequel ladite zone d'intérêt est la zone active d'une diode et ladite particule est déposée sur ou à la périphérie d'au moins l'une des électrodes de la diode, ledit groupement à affinité pour le matériau à cristalliser étant exposé face à la zone active.

16. Procédé selon l'une quelconque des revendications 1 à 12, dans lequel ledit matériau à cristalliser est un isolant, par exemple le polystyrène.

17. Procédé selon la revendication 16, dans lequel ladite zone d'intérêt est l'oxyde de grille d'un transistor ou le diélectrique d'une capacité et ladite particule est déposée à la périphérie des électrodes.

## Patentansprüche

1. Verfahren zum Orientieren der Kristallisation eines Materials auf einer Oberflächenzone wenigstens einer Seite eines Substrats, umfassend mindestens die Schritte, die bestehen in:
i. Bestimmen, auf der genannten Seite, der Oberfläche, als Zielzone bezeichnet, auf welcher der kristalline Niederschlag gebildet werden soll,
ii. Abscheiden, auf der genannten Seite und dem Umfang der genannten Zielzone, wenigstens eines Partikels, das dazu bestimmt ist, einen Kristallisationskeim zu bilden,
iii. In Kontakt Bringen des genannten Partikels mit wenigstens dem genannten Material, das zu kristallisieren ist,
iv. Einstellen von Bedingungen, die für die Kristallisation des genannten Materials günstig sind, wenigstens an dem genannten Kontaktpunkt zwischen dem genannten Partikel und dem genannten Material, das zu kristallisieren ist,
wobei die Oberfläche des genannten Partikels zum Teil funktionalisiert ist durch wenigstens eine Affinitätsgruppe für das genannte zu kristallisierende Material, wobei die genannte Gruppe wenigstens ein chemisches Merkmal aufweist, das mit wenigstens einem Teil der chemischen Struktur des zu kristallisierenden Materials identisch oder verwandt ist, und dass das genannte Partikel in Schritt ii. so abgeschieden wird, dass die genannte Gruppe auf der der zu kristallisierenden Zone zugewandten Seite freiliegt.

2. Verfahren nach Anspruch 1, bei dem der auf der Zielzone gebildete kristalline Niederschlag durch einen Einkristall des genannten Materials gebildet wird.

3. Verfahren nach einem der vorstehenden Ansprüche, bei dem das genannte Partikel anorganisch ist, insbesondere ganz oder teilweise in der Form eines Oxids, vorteilhafterweise von Silizium, Aluminium oder Bariumtitanat, und insbesondere ein Siliziumpartikel ist.

4. Verfahren nach einem der vorstehenden Ansprüche, mit Verwendung eines Partikels, dessen Oberfläche zum Teil funktionalisiert ist durch eine Gruppe, die wenigstens eine aromatische Verbindung, insbesondere Phenylverbindung aufweist, für ein zu kristallisierendes aromatisches Material.

5. Verfahren nach dem vorstehenden Anspruch, bei dem das genannte teilweise funktionalisierte Partikel erhalten wird durch Aufpfropfen, auf ein Partikel, das auf einem Teil seiner Oberfläche Hydroxylgruppen aufweist, eines Moleküls, das außer der genannten Gruppe mit der aromatischen Verbindung, insbesondere Phenylverbindung, wenigstens eine Silan- oder Chlor- oder Isocyanatgruppe aufweist, die in der Lage ist, mit einer Hydroxylgruppe der Oberfläche zu reagieren, um eine kovalente Bindung einzugehen.

6. Verfahren nach dem vorstehenden Anspruch, **dadurch gekennzeichnet, dass** das genannte Molekül Phenyl-tri-isopropylsilan oder Phenyl-tri-methoxysilan, vorzugsweise Phenyl-tri-isopropylsilan ist.

7. Verfahren nach Anspruch 5 oder 6, bei dem das genannte Partikel, das auf einem Teil seiner Oberfläche Hydroxylgruppen aufweist, erhalten wird durch eine Plasmabehandlung eines nicht funktionalisierten Partikels, insbesondere mit einem O₂-plasma, um auf dem Teil der Oberfläche des Partikels, der dem Plasma ausgesetzt ist, Hydroxylgruppen zu erzeugen.

8. Verfahren nach einem der vorstehenden Ansprüche, bei dem das genannte Partikel außerdem auf einem Teil seiner Oberfläche, der von demjenigen, der für die genannte Affinitätsgruppe für das zu kristallisierende Material funktionalisiert ist, außerdem durch wenigstens eine Gruppe funktionalisiert ist, die keine Affinität zu dem zu kristallisierenden Material aufweist.

9. Verfahren nach Anspruch 8, bei dem die Affinitätsgruppen für das zu kristallisierende Material und die Gruppen ohne Affinität zu dem zu kristallisierenden Material auf verschiedenen Seiten, vorzugsweise entgegengesetzten Seiten des genannten Partikels angeordnet sind.

10. Verfahren nach einem der vorstehenden Ansprüche, bei dem das genannte Partikel in Schritt (ii) auf der Oberfläche der genannten Seite in der gewünschten Orientierung durch Siebdruck, Tintenstrahl, Stempel oder Vakuumabscheidung aufgebracht wird, insbesondere mit Hilfe eines Stempels aus einem Elastomer, insbesondere Polydimethylsiloxan.

11. Verfahren nach einem der vorstehenden Ansprüche, **dadurch gekennzeichnet, dass** das In Kontakt Bringen des genannten Partikels mit dem genannten zu kristallisierenden Material in Schritt (iii) erreicht wird durch Abscheiden eines durchgehenden Films eines Lösungsmittels, das wenigstens das genannte zu kristallisierende Material enthält, auf der genannten Zielzone, wobei der Film mit dem genannten Partikel in Kontakt kommt.

12. Verfahren nach dem vorstehenden Anspruch, bei dem der Schritt (iv) wenigstens das Verdampfen des genannten Lösungsmittels enthält.

13. Verfahren nach einem der vorstehenden Ansprüche, bei dem das genannte zu kristallisierende Material ein organischer Halbleiter ist.

14. Verfahren nach Anspruch 13, bei dem die genannte Zielzone die Kanalzone eines Transistors ist und das genannte Partikel auf wenigstens einer der Elektroden dieses Transistors oder dem Rand dieser Elektrode abgeschieden wird, wobei die genannte Affinitätsgruppe für das zu kristallisierende Material auf der der Kanalzone zugewandten Seite freiliegt.

15. Verfahren nach Anspruch 13, bei dem die genannte Zielzone die Aktivitätszone einer Diode ist und das genannte Partikel auf wenigstens einer der Elektroden der Diode oder dem Rand dieser Elektrode abgeschieden wird, wobei die genannte Affinitätsgruppe für das zu kristallisierende Material auf der der Aktivitätszone zugewandten Seite freiliegt.

16. Verfahren nach einem der Ansprüche 1 bis 12, bei dem das genannte zu kristallisierende Material ein Isolator ist, beispielsweise Polystyrol.

17. Verfahren nach Anspruch 16, bei dem die genannte Zielzone das Gate-Oxid eines Transistors oder das Dielektrikum eines Kondensators ist und das genannte Partikel am Rand der Elektroden abgeschieden wird.

## Claims

1. A method useful for orienting the crystallization of a material over a surface zone of at least one face of a substrate, comprising at least the steps consisting in:
i. determining, on said face, the surface over which the crystalline deposit must be formed, referred to as the zone of interest,
ii. depositing, on said face and at the periphery of said zone of interest, at least one particle dedicated to forming a crystallization nucleus,
iii. bringing said particle into contact with at least said material to be crystallized,
iv. exposing at least said point of contact between said particle and said material to be crystallized to conditions favorable to the crystallization of said material,
the surface of said particle being partly functionalized with at least one group having an affinity for said material to be crystallized, said group possessing at least one unit having a chemical nature identical or similar to at least one part of the chemical structure of said material to be crystallized, and in that said particle is deposited in step ii. so as to expose said group opposite the zone to be crystallized.

2. The method as claimed in claim 1, wherein the crystalline deposit formed on the zone of interest consists of a single monocrystalline grain of said material.

3. The method as claimed in either one of the preceding claims, wherein said particle is inorganic, in particular is totally or partially formed from an oxide, advantageously from silica, from alumina or from barium titanate, and more particularly is a silica particle.

4. The method as claimed in any one of the preceding claims, using a particle of which the surface is partly functionalized with a group possessing at least one aromatic unit, in particular phenyl unit, for a material to be crystallized of aromatic chemical nature.

5. The method as claimed in the preceding claim, wherein said partially functionalized particle is obtained by grafting, onto a particle exhibiting hydroxyl functions on a part of its surface, a molecule exhibiting, in addition to said group having an aromatic, in particular phenyl, unit, at least one silane or chlorine or isocyanate function capable of interacting with a hydroxyl function of the surface so as to form a covalent bond.

6. The method as claimed in the preceding claim, **characterized in that** said molecule is phenyltriisopropylsilane or phenyltrimethoxysilane, preferably phenyltriisopropylsilane.

7. The method as claimed in claim 5 or 6, wherein said particle exhibiting hydroxyl functions on a part of its surface is obtained via a plasma treatment of a nonfunctionalized particle, in particular a dioxygen plasma, so as to generate hydroxyl functions on the part of the surface of the particle exposed to the plasma.

8. The method as claimed in any one of the preceding claims, wherein said particle is also functionalized, on a part of its surface distinct from that functionalized with said group having an affinity for said material to be crystallized, with at least one group devoid of affinity for said material to be crystallized.

9. The method as claimed in claim 8, wherein said groups having an affinity for the material to be crystallized and said groups devoid of affinity for said material are placed on different faces, preferably opposite faces, of said particle.

10. The method as claimed in any one of the preceding claims, wherein said particle is deposited according to the desired orientation in step (ii) at the surface of said face by screen printing, inkjet, stamping or vacuum deposition, in particular using an elastomer stamping pad, in particular a polydimethylsiloxane stamping pad.

11. The method as claimed in any one of the preceding claims, **characterized in that** the bringing of said particle into contact with said material to be crystallized in step (iii) is carried out by depositing on said zone of interest a continuous film of a solvent medium comprising at least said material to be crystallized, said film coming into contact with said particle.

12. The method as claimed in the preceding claim, wherein step (iv) comprises at least the evaporation of said solvent medium.

13. The method as claimed in any one of the preceding claims, wherein said material to be crystallized is an organic semiconductor.

14. The method as claimed in claim 13, wherein said zone of interest is the zone of the channel of a transistor and said particle is deposited on or at the periphery of at least one of the electrodes of said transistor, said group having an affinity for the material to be crystallized being exposed opposite the zone of the channel.

15. The method as claimed in claim 13, wherein said zone of interest is the active zone of a diode and said particle is deposited on or at the periphery of at least one of the electrodes of the diode, said group having an affinity for the material to be crystallized being exposed opposite the active zone.

16. The method as claimed in any one of claims 1 to 12, wherein said material to be crystallized is an insulator, for example polystyrene.

17. The method as claimed in claim 16, wherein said zone of interest is the gate oxide of a transistor or the dielectric of a capacitor and said particle is deposited at the periphery of the electrodes.
